# EUROPEAN PATENT APPLICATION

(11) **EP 1 505 588 A2**
(43) Date of publication of application: **09.02.2005**
(21) Application number: 04018564.7
(22) Date of filing: 05.08.2004
(51) Int. Cl.: G11B 7/26, B29D 17/00, G03F 7/00

(54) **Method for manufacturing a photoresist-coated glass board, method for manufacturing a stamper and method for manufacturing a recording medium**

(30) Priority: 08.08.2003 JP 2003290440
(71) Applicant: TDK Corporation, Tokyo 103-8272 (JP)
(72) Inventor: Oyake, Hisaji c/o TDK Corporation, Tokyo 103-8272 (JP)
(74) Representative: HOFFMANN - EITLE

(57) **Abstract**

A method for manufacturing a photoresist-coated glass board (21) includes steps of forming a resin layer (22) containing a benzophenone system compound on a glass board (21), forming a photoresist layer (23) on the resin layer (22), intermittently projecting a laser beam for exposure having a wavelength λ of 100 nm to 300 nm onto the photoresist layer (23), forming a latent image of a pit pattern so that a half-width *l* of a shortest pit length is equal to or shorter than 0.65 λ, and developing the photoresist layer (23) in which the latent image is formed to form a pit pattern in the photoresist layer (23).

According to thus constituted method for manufacturing a photoresist-coated glass board (21), a photoresist-coated glass board (21) can be formed with pits of a pit pattern in a desired manner using a laser beam having a short wavelength.

## Description

### BACKGROUND OF THE INVENTION

The present invention relates to a method for manufacturing a photoresist-coated glass board and, particularly, to a method for manufacturing a photoresist-coated glass board which can be formed with pits of a pit pattern in a desired manner using a laser beam having a short wavelength.

Further, the present invention relates to a method for manufacturing a stamper and, particularly, to a method for manufacturing a stamper formed with a pit pattern having a desired height.

Furthermore, the present invention relates to a method for manufacturing a recording medium and, particularly, to a method for manufacturing a recording medium having a substrate formed with a pit pattern having a desired cross section.

### DESCRIPTION OF THE PRIOR ART

In a process for manufacturing a stamper used for manufacturing an optical recording medium, one known method for forming a minute pit pattern in a photoresist layer on a glass board is the resist pattern forming method employing photo-lithography.

Further, as a method for manufacturing a stamper using a photoresist-coated glass board having a pit pattern formed in accordance with this kind of resist pattern forming method, there is known a method for fabricating a stamper by forming an electroless nickel layer and an electrolytic nickel layer on the surface of the pit pattern An example of such a method for fabricating a photoresist-coated glass board for producing a stamper is disclosed, for example, in Japanese Patent Application Laid Open No. 2000-11465.

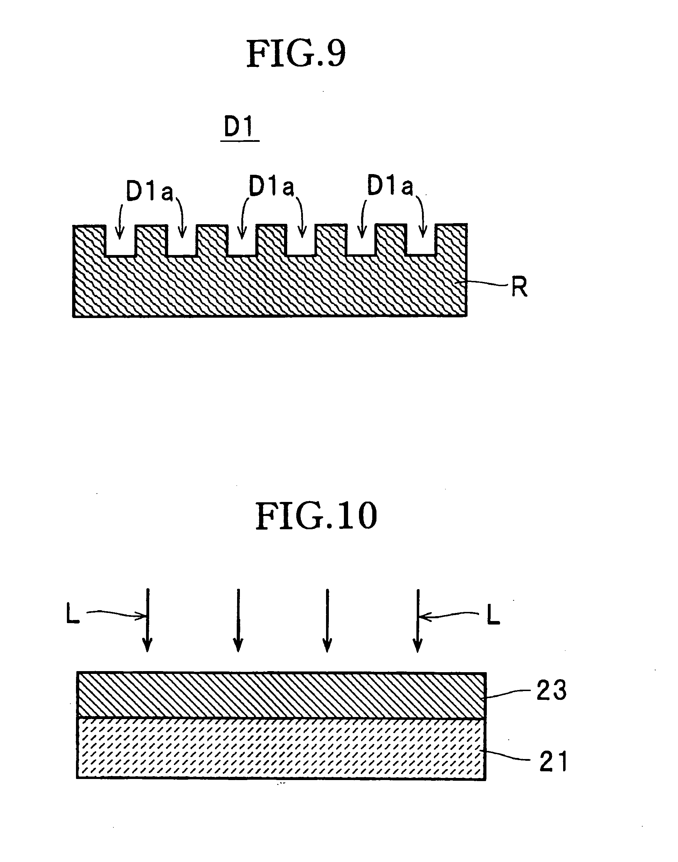

When a stamper is fabricated in accordance with this kind of pit pattern forming method and stamper fabricating method, a photoresist material such as novolac system resin or polystyrene system resin is, as shown in Figure 10, first applied using a spin coating process onto the surface of a glass substrate 21 to form a photoresist layer 23, for example.

Then, as shown in Figure 10, a laser beam L having a wavelength of 351 nm, for example, is intermittently projected onto the photoresist layer 23, thereby forming a latent image therein.

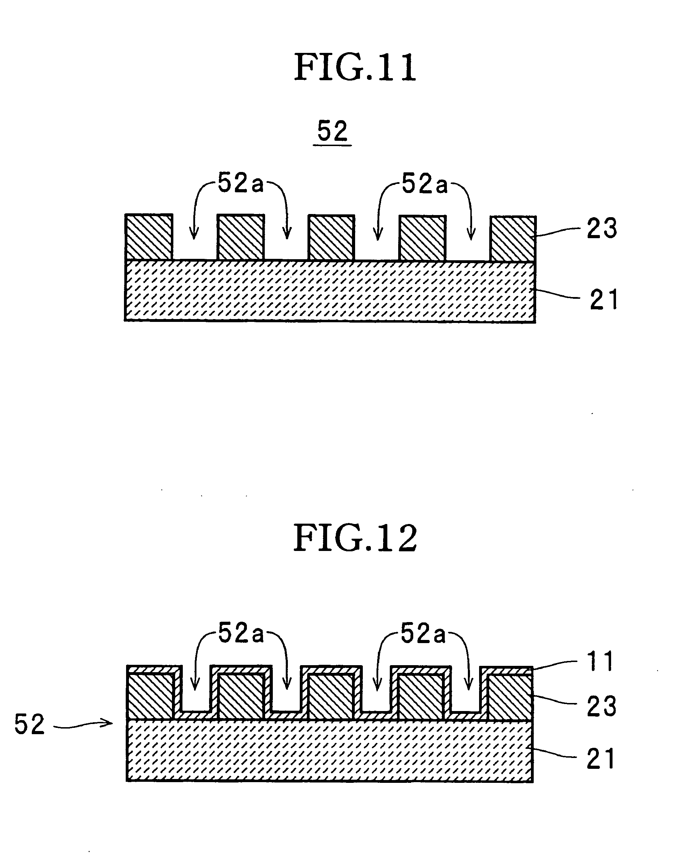

Further, the photoresist layer 23 formed with the latent images formed is developed. As a result, as shown in Figure 11, portions irradiated with the laser beam L are removed so that a concavo-convex pit train 52a is spirally formed in the photoresist layer 23, whereby a photoresist-coated glass board formed with the concavo-convex pit train 52a in the photoresist layer 23 is fabricated.

Then, as shown in Figure 12, an electroless nickel layer 11 is formed on the surface of the pit train 52a formed in the photoresist layer 23 using an electroless deposition process, for example.

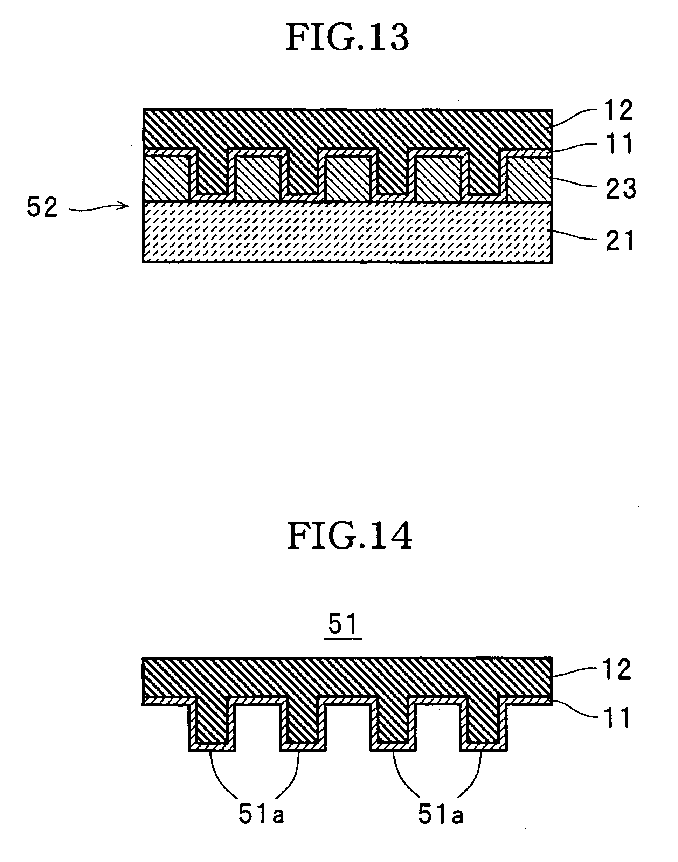

Further, as shown in Figure 13, an electrolyte nickel layer 12 is formed on the electroless nickel layer 11 by an electrolytic plating process using the electroless nickel layer 11 as an electrode.

Then, a laminate consisting of the photoresist layer 23, the electroless nickel layer 11 and the electrolyte nickel layer 12 is peeled off the glass board 21 and the laminate is immersed in a photoresist remover solution, thereby dissolving the photoresist layer 23. As a result, as shown in Figure 14, a stamper 51 including the electroless nickel layer 11 and the electrolyte nickel layer 12 is fabricated. At this time, a concavo-convex pit pattern 51a, more accurately, a negative pattern of the pit pattern 51a formed in the photoresist layer 23 is spirally formed on the lower surface of the stamper 51.

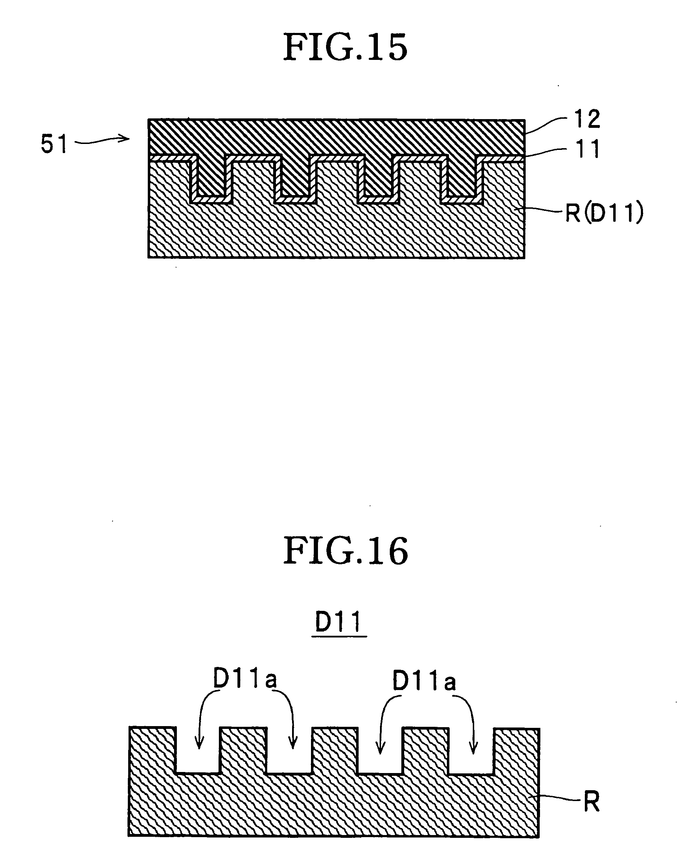

When a disc-like substrate D11 for an optical recording medium shown in Figure 15 is fabricated using the thus fabricated stamper 51, the stamper 51 is set in a mold for injection molding and as shown in Figure 15, resin R is injected into the mold.

As a result, as shown in Figure 16, the pit pattern 51a of the stamper 51 is transferred onto the resin R to form a pit pattern D11a thereon, whereby the disc-like substrate D11 formed with the pit pattern is fabricated.

The recording capacity of optical recording media has been increasing year by year. For achieving such capacity increase, it is necessary to decrease the size of the pits D11a formed on the disc-like substrate D11 or narrow the pitch between neighboring pit trains.

From this viewpoint, it is necessary to reduce the size of the pit 52a of the pit pattern of the stamper 51 and narrow the track pitch between neighboring pit trains thereof in comparison with the conventional stamper, and for this purpose, a laser beam L having a shorter wavelength, for example, wavelength equal to or shorter than 300 nm, than that of the laser beam L conventionally used is recently used for forming the pit pattern of a stamper. This is because the shorter the wavelength of the laser beam L is, the smaller is the spot diameter of the laser beam L projected onto the photoresist layer 23, thereby reducing the size of pits 52a of the pit pattern of the stamper and narrowing the track pitch between neighboring pit trains thereof.

However, the conventional pit pattern forming method has following defects.

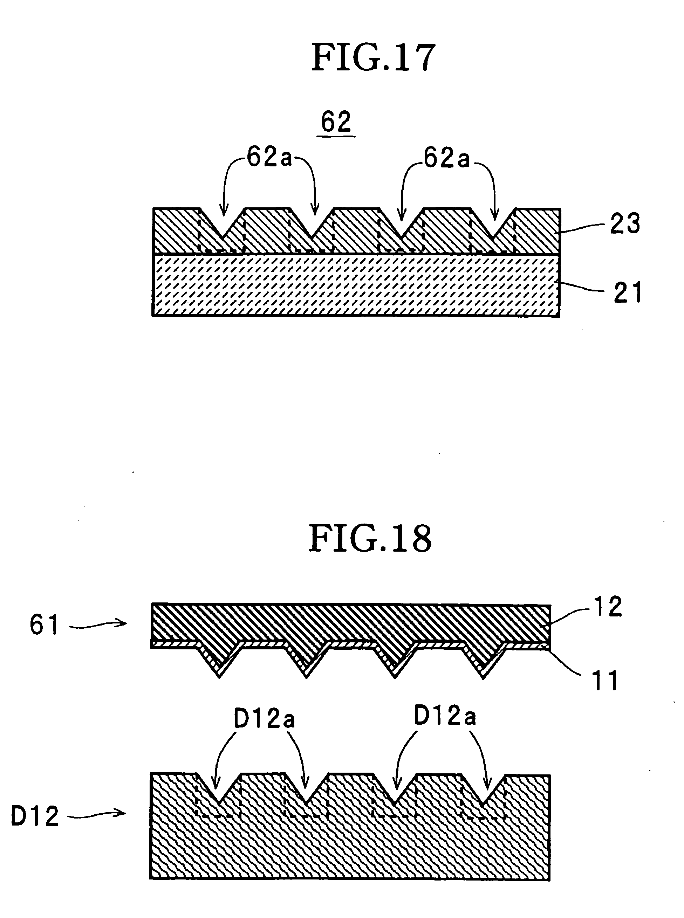

Specifically, in the conventional pit pattern forming method, although the photoresist layer 23 is normally formed of a photoresist material of the novolac resin system, since the photoresist material of the novolac resin system resin resists exposure to a laser beam L having a short wavelength, for example, a wavelength of 100 nm to 300 nm, it is difficult to sufficiently expose the photoresist material at the bottom portion of the photoresist layer 23 in the vicinity of the surface of the glass board where the laser beam L is attenuated. Therefore, as shown in Figure 17, pits 62a each having a smaller depth than the desired depth indicated by broken lines in Figure 17 may be formed in the photoresist-coated glass board 62.

In the case where a disc-like substrate D11 is fabricated using a stamper 61 (see Figure 18) fabricated using the thus fabricated photoresist-coated glass board 62, pits D12a each having a smaller depth than a desired depth indicated by a broken line in Figure 18 are, as shown in Figure 18, formed in the disc-like substrate D11.

It is necessary to form each of the pits D12a in the disc-like substrate D12 so as to have the desired depth for correctly reading data from the optical recording medium. Therefore, in the case where pits D12a each having a smaller depth than the desired depth are formed in the disc-like substrate D12 in this manner, correct reading of data from the optical recording medium is difficult because jitter error occurs when data recorded in the optical recording medium are read.

It might be considered possible to cope with this situation by projecting a laser beam having high intensity onto the photoresist layer 23 in order to sufficiently expose the bottom portion of the photoresist layer 23. However, if a laser beam having high intensity is projected onto the photoresist layer 23, the surface of the photoresist layer 23 is exposed to the laser beam over a wider region, as shown in Figure 17, so that pits 62a each having a V shaped cross-section are formed. Therefore, when a stamper is fabricated using the thus fabricated photoresist-coated glass board and a disc-like substrate is fabricated to fabricate an optical recording medium, it is difficult to correctly read data recorded in the optical recording medium. Thus, this solution cannot be adopted.

Another solution to the above problem that might be considered is to avoid use of a novolac system resin and use instead a chemical amplification type photoresist material which can be easily exposed to a laser beam having a short wavelength. Illustrative examples of the chemical amplification type photoresist material include a photoresist material containing a polymer obtained by protecting the hydroxyl group of polyvinyl phenol with a t-butoxycarbonyl group, and a photo acid generator.

In the case where a photoresist layer is formed of this kind of chemical amplification type photoresist material, when a laser beam L is projected thereon, the exposure of the polymer is assisted by acid generated by the action of the photo acid generator, so that even if a laser beam L having a short wavelength is employed, the bottom portion of the photoresist layer can be sufficiently exposed.

However, in the case where a photoresist layer is formed of this kind of chemical amplification type photoresist material, the acid generated by the action of the photo acid generator is neutralized by ammonia or the like in the air over the course of time. Therefore, the degree of exposure of the photoresist layer at which the projection of the laser beam L is started becomes different from that of the photoresist layer at which the projection of the laser beam L is terminated due to the time difference. As a result, it is difficult to form a uniform pit pattern. Thus, this solution cannot be adopted.

### SUMMARY OF THE INVENTION

It is therefore an object of the present invention to provide a method for manufacturing a photoresist-coated glass board which can be formed with pits of a pit pattern in a desired manner using a laser beam having a short wavelength.

It is another object of the present invention to provide a method for manufacturing a stamper formed with a pit pattern having a desired height.

It is a further object of the present invention to provide a method for manufacturing a recording medium having a substrate formed with a pit pattern having a desired cross section.

The above and other objects of the present invention can be accomplished by a method for manufacturing a photoresist-coated glass board comprising steps of forming a resin layer containing a benzophenone system compound on a glass board, forming a photoresist layer on the resin layer, intermittently projecting a laser beam for exposure having a wavelength λ of 100 nm to 300 nm onto the photoresist layer, forming a latent image of a pit pattern so that a half-width *l* of a shortest pit length is equal to or shorter than 0.65 λ, and developing the photoresist layer in which the latent image is formed to form a pit pattern in the photoresist layer.

According to the present invention, since a latent image is formed in a photoresist layer by forming a resin layer containing a benzophenone system compound on a glass board, forming the photoresist layer on the resin layer and intermittently projecting a laser beam for exposure having a wavelength λ of 100 nm to 300 nm onto the photoresist layer, it is possible to assist the exposure of the photoresist layer by the reaction of a benzophenone system compound. Therefore, even at the bottom portion of the photoresist layer where the laser beam for exposure is attenuated, the photoresist layer can be reliably exposed to the laser beam and a latent image can be reliably formed using a laser beam having a short wavelength down to the bottom portion of the photoresist layer. Accordingly, it is possible to accurately form a pit pattern including pits having a desired depth in the photoresist layer.

Further, according to the present invention, since a pit pattern can be formed using a laser beam having low intensity, it is possible to reliably prevent pits having a V shaped cross section from being formed in a photoresist-coated glass board and it is possible to uniformly form pits having a good shape with a sharp edge.

Therefore, according to the present invention, a ROM type optical recording medium having a good jitter characteristic can be manufactured using a stamper onto which the thus formed pit pattern is transferred.

In a preferred aspect of the present invention, the resin layer is formed so as to have a thickness of 50 nm to 200 nm and the photoresist layer is formed so as to have a thickness of 30 nm to 100 nm.

In a study done by the inventors of the present invention, it was found that in the case where a resin layer was formed so as to have a thickness of 50 nm to 200 nm and a photoresist layer was formed so as to have a thickness of 30 nm to 100 nm, the effect of the reaction in the resin layer could be increased and a latent image could be reliably formed using a laser beam having a short wavelength down to the bottom portion of the photoresist layer, whereby a pit pattern including pits having a desired depth could be more reliably formed.

Therefore, according to this preferred aspect of the present invention, even when a laser beam having a wavelength λ is used for forming pits so that the half-width *l* of the shortest pit length is equal to or shorter than 0.65 λ, pits having a good shape with a sharp edge can be reliably formed.

The above and other objects of the present invention can be also accomplished by a method for manufacturing a stamper comprising steps of forming a resin layer containing a benzophenone system compound on a substrate, forming a photoresist layer on the resin layer, intermittently projecting a laser beam for exposure having a wavelength λ of 100 nm to 300 nm onto the photoresist layer, forming a latent image of a pit pattern so that a half-width 1 of a shortest pit length is equal to or shorter than 0.65 λ, developing the photoresist layer in which the latent image is formed to form a pit pattern in the photoresist layer, and transferring the pit pattern.

According to the present invention, since a photoresist-coated glass board formed with a pit pattern including pits having a desired depth is fabricated and a stamper is fabricated using the thus fabricated photoresist-coated glass board, it is possible to manufacture a stamper formed with a pit pattern having a desired height.

In a preferred aspect of the present invention, the resin layer is formed so as to have a thickness of 50 nm to 200 nm and the photoresist layer is formed so as to have a thickness of 30 nm to 100 nm.

The above and other objects of the present invention can be also accomplished by a method for manufacturing an optical recording medium comprising steps of forming a resin layer containing a benzophenone system compound on a substrate, forming a photoresist layer on the resin layer, intermittently projecting a laser beam for exposure having a wavelength λ of 100 nm to 300 nm onto the photoresist layer, forming a latent image of a pit pattern so that a half-width 1 of a shortest pit length is equal to or shorter than 0.65 λ, developing the photoresist layer in which the latent image is formed to form a pit pattern in the photoresist layer, transferring the pit pattern to fabricate a stamper, and transferring the pit pattern transferred onto the stamper onto a substrate for a recording medium to fabricate the substrate for an optical recording medium.

According to the present invention, since a photoresist-coated glass board formed with a pit pattern including pits having a desired depth is fabricated, a stamper is fabricated using the thus fabricated photoresist-coated glass board and a substrate for a recording medium is fabricated using the thus fabricated stamper, it is possible to manufacture a recording medium including a substrate formed with a pit pattern including pits having a desired cross section.

In a preferred aspect of the present invention, the resin layer is formed so as to have a thickness of 50 nm to 200 nm and the photoresist layer is formed so as to have a thickness of 30 nm to 100 nm.

The above and other objects and features of the present invention will become apparent from the following description made with reference to the accompanying drawings.

### BRIEF DESCRIPTION OF THE DRAWINGS

Figure 1 is a schematic cross-sectional view showing a stamper fabricated by a method for manufacturing a stamper which is a preferred embodiment of the present invention.
Figure 2 is a block diagram of a stamper manufacturing apparatus which is a preferred embodiment of the present invention.
Figure 3 shows a step for manufacturing a stamper and is a schematic cross-sectional view showing a state in which a resin layer is formed on a glass board.
Figure 4 shows a step for manufacturing a stamper and is a schematic cross-sectional view showing a state in which a laser beam is projected onto a photoresist layer formed on a resin layer.
Figure 5 shows a step for manufacturing a stamper and is a schematic cross-sectional view showing a photoresist-coated glass board.
Figure 6 shows a step for manufacturing a stamper and is a schematic cross-sectional view showing a state in which an electroless nickel layer is formed on the surface of a photoresist-coated glass board.
Figure 7 shows a step for manufacturing a stamper and is a schematic cross-sectional view showing a state in which an electrolyte nickel layer is formed on an electroless nickel layer.
Figure 8 shows a step for manufacturing a disc-like substrate for an optical recording medium and is a schematic cross-sectional view showing a state in which a concavo-convex pattern of a stamper is transferred onto a disc-like substrate.
Figure 9 is a schematic cross-sectional view showing a disc-like substrate fabricated using a stamper.
Figure 10 is a schematic cross-sectional view showing a state in which a laser beam is projected onto a photoresist layer formed on a glass board in a conventional method for manufacturing a stamper.
Figure 11 is a schematic cross-sectional view showing a photoresist-coated glass board.
Figure 12 is a schematic cross-sectional view showing a state in which an electroless nickel layer is formed on the surface of a photoresist-coated glass board.
Figure 13 is a schematic cross-sectional view showing a state in which an electrolyte nickel layer is formed on an electroless nickel layer.
Figure 14 is a schematic cross-sectional view showing a conventional stamper.
Figure 15 is a schematic cross-sectional view showing a state in which a concavo-convex pattern of a stamper is transferred onto a disc-like substrate.
Figure 16 is a schematic cross-sectional view showing a conventional disc-like substrate fabricated using a stamper.
Figure 17 is a schematic cross-sectional view showing a photoresist-coated glass board fabricated in accordance with a conventional manufacturing method.
Figure 18 is a schematic cross-sectional view showing a stamper fabricated using a photoresist-coated glass board and a disc-like substrate fabricated using a stamper.

### DESCRIPTION OF THE PREFERRED EMBODIMENT

A preferred embodiment of a method for forming a pit pattern according to the present invention will now be described. In the following description, elements having the same structures as those of the stamper 51 and the photoresist-coated glass board 52 in the above described conventional pit pattern forming method and stamper manufacturing method are assigned the same reference symbols and repeated explanation will be omitted.

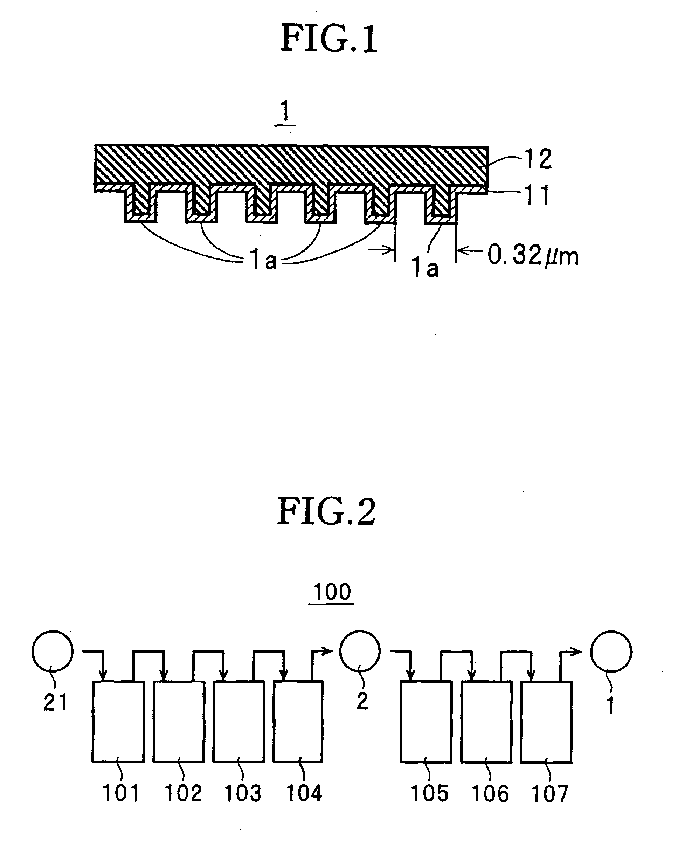

Figure 1 is a schematic cross-sectional view showing a stamper fabricated by a method for manufacturing a stamper which is a preferred embodiment of the present invention.

The stamper 1 shown in Figure 1 is used for manufacturing a disc-like substrate for an optical recording medium and fabricated using a photoresist-coated glass board in which a pit pattern is formed in accordance with a pit pattern forming method according to the present invention.

As shown in Figure 1, the stamper 1 includes an electroless nickel layer 11 and an electrolyte nickel layer 12 and is constituted to be platelike as a whole. On the lower surface of the stamper 1, minute convex portions 1a are spirally formed for forming a minute pit pattern on the surface of a disc-like substrate for an optical recording medium. The pitch between neighboring convex portions 1a, 1a is determined in accordance with the pitch of the pit pattern to be formed on the surface of the disc-like substrate, and is 0.32 µm, for example.

Figure 2 is a block diagram of a stamper manufacturing apparatus for manufacturing the stamper 1 shown in Figure 1.

As shown in Figure 2, a stamper manufacturing apparatus 100 includes a resin layer forming apparatus 101, a photoresist layer forming apparatus 102, an exposing apparatus 103, a developing apparatus 104, a conductive layer forming apparatus 105, a laminate forming apparatus 106 and a peeling apparatus 107, and is constituted so as to fabricate the stamper 1 using a photoresist-coated glass board.

Here, the resin layer forming apparatus 101, the photoresist layer forming apparatus 102, the exposing apparatus 103 and the developing apparatus 104 constitute a photoresist-coated glass board manufacturing apparatus.

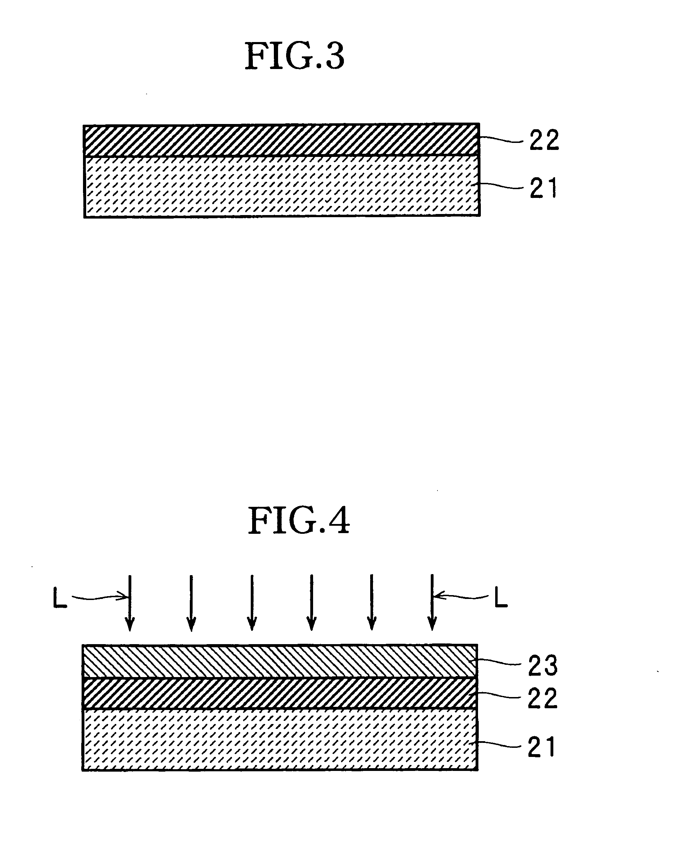

Figures 3 to 8 show steps of a process for manufacturing the stamper 1.

As shown in Figure 3, a thin resin layer 22 having a thickness of about 150 µm, for example, is first formed on the glass board 21 by the resin layer forming apparatus 101.

More specifically, a coating solution for forming the resin layer 22 is first prepared. The coating solution contains a benzophenone system compound reacting to a laser beam L having a wavelength of 100 nm to 300 nm, for example, and a thermosetting resin. In this embodiment, 4, 4'-bis(diethylamino) benzophenone is employed as the benzophenone system compound and a melamine resin obtained by synthesizing melamine, formalin and the like is employed as the thermosetting resin.

In a study done by the inventors of the present invention, it was confirmed that the content of the benzophenone system compound in the coating solution is preferably 10 weight % to 70 weight % and that when the content of the benzophenone system compound in the coating solution is less than 10 weight %, the benzophenone system compound does not sufficiently react and when the content of the benzophenone system compound in the coating solution exceeds 70 weight %, the strength of the resin layer 22 becomes insufficient.

Here, instead of 4, 4'-bis (diethylamino) benzophenone, 4, 4'-bis (dimethylamino) benzophenone may be employed and instead of a melamine resin, an ultraviolet ray curable resin may be employed. Further, various additives such as an adhesive auxiliary agent, a surface-active agent and the like may be added to the coating solution.

The thus prepared coating solution is stored in the resin layer forming apparatus 101.

Then, the resin layer forming apparatus 101 forms a coupling agent layer (not shown) on the surface of a glass board 21, which is polished to be flat, and the coating solution is next applied onto the surface of glass board 21 using a spin coating process. At this time, the amount and concentration of the coating solution and the rotational speed of the spin coating apparatus are adjusted so that a resin layer 22 having a thickness of about 150 µm is formed on the glass board 21.

Further, the glass board 21 is heat treated to harden the coating layer and, as shown in Figure 3, a resin layer 22 having a thickness of about 150 µm is formed on the surface of the glass board 21.

Here, in the case where an ultraviolet ray curable resin is used when the coating solution is prepared, the coating layer is hardened by projecting an ultraviolet ray onto the coating layer.

Further, as shown in Figure 4, the photoresist layer forming apparatus 102 applies a photoresist material on the surface of the resin layer 22 using a spin coating process, for example, thereby forming on the resin layer 22 a thin photoresist layer 23 having a thickness of about 60 nm, for example.

More specifically, a photoresist material such as "DVR100" (Product Name) manufactured by Zeon Corporation is applied by the photoresist layer forming apparatus 102 onto the surface of the resin layer 22 using a spin coating process. At this time, the amount and concentration of the photoresist material and the rotational speed of the spin coating apparatus are adjusted so that a photoresist layer 23 having a thickness of about 60 nm, for example, is formed on the resin layer 22.

Then, the photoresist layer 23 is baked by the photoresist layer forming apparatus 102 to evaporate solvent remaining in the photoresist layer 23 and, as shown in Figure 4, a photoresist layer 23 having a thickness of about 60 nm is formed on the resin layer 22.

Further, as shown in Figure 4, a laser beam L having a predetermined intensity and a wavelength of 266 nm, for example, is intermittently projected by the exposing apparatus 103 onto the photoresist layer 23 to expose the photoresist layer 23, thereby forming a latent image in the photoresist layer 23.

More specifically, a laser beam L having a wavelength λ of 266 nm is projected onto regions of the photoresist layer 23 at the intensity of 1.0 mJ/m at which pits are to be formed and a latent image of a pit pattern is spirally formed in the photoresist layer 23 in such a manner that the pitch thereof is about 0.32 µm, the width thereof is about 0.15 µm and the half-width *l* thereof is equal to or shorter than 0.65λ. At this time, the benzophenone system compound contained in the resin layer absorbs the projected laser beam L and assists the exposure reaction of the photoresist material at the bottom portion of the photoresist layer 23. As a result, even at the bottom portion of the photoresist layer 23 where the laser beam L is attenuated, the photoresist material is reliably exposed to the laser beam L and a latent image is reliably formed down to the bottom portion of the photoresist layer 23.

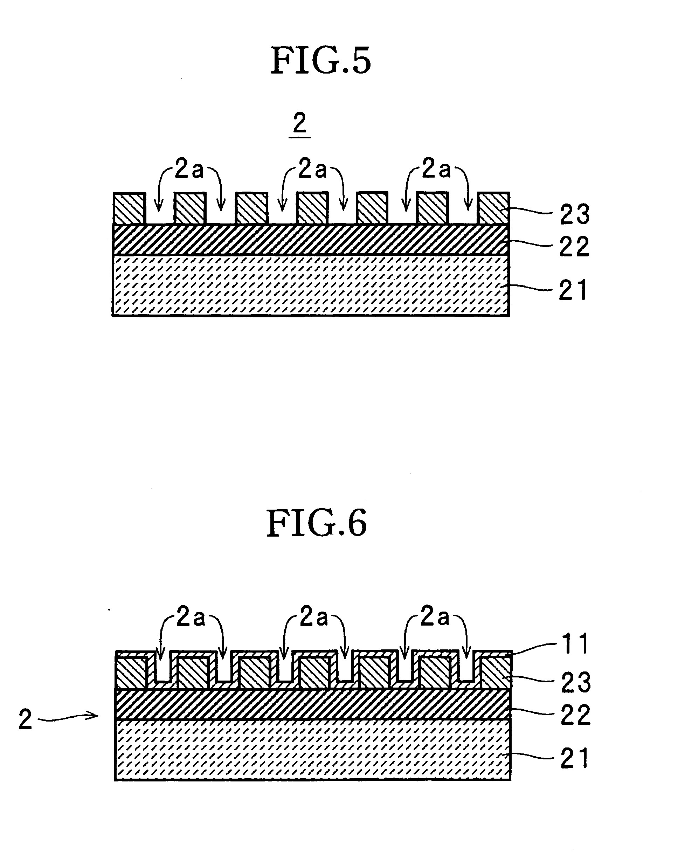

Further, as shown in Figure 5, the photoresist layer 23 in which the latent image was formed is developed by the developing apparatus 104 and portions irradiated with the laser beam L are removed. As a result, pits 2a are formed in the photoresist layer 23 and a concavo-convex pit pattern is formed in the photoresist layer 23, thereby fabricating a photoresist-coated glass board 2.

As described above, since a latent image is reliably formed down to the bottom portion of the photoresist layer 23, it is possible to fabricate a photoresist-coated glass board 2 formed with pits 2a having a desired shape.

Then, as shown in Figure 6, the conductive layer forming apparatus 105 conducts electroless deposition processing on the surface of the pit pattern of the photoresist layer 23 to form an electroless nickel layer 11 on the surface of the pit pattern of the photoresist layer 23. As a result, a conductive layer is formed on the surface of the photoresist layer 23 to impart conductivity thereto. The material used to form the conductive layer for imparting conductivity to the surface of the photoresist layer 23 is not limited to nickel and any of various metal materials can be used for forming the conductive layer on the surface of the photoresist layer 23. Further, the process for forming the conductive layer is not limited to the electroless deposition process and any of various film forming processes such as the vapor deposition process, sputtering process and the like can be used for forming the conductive layer on the surface of the photoresist layer 23.

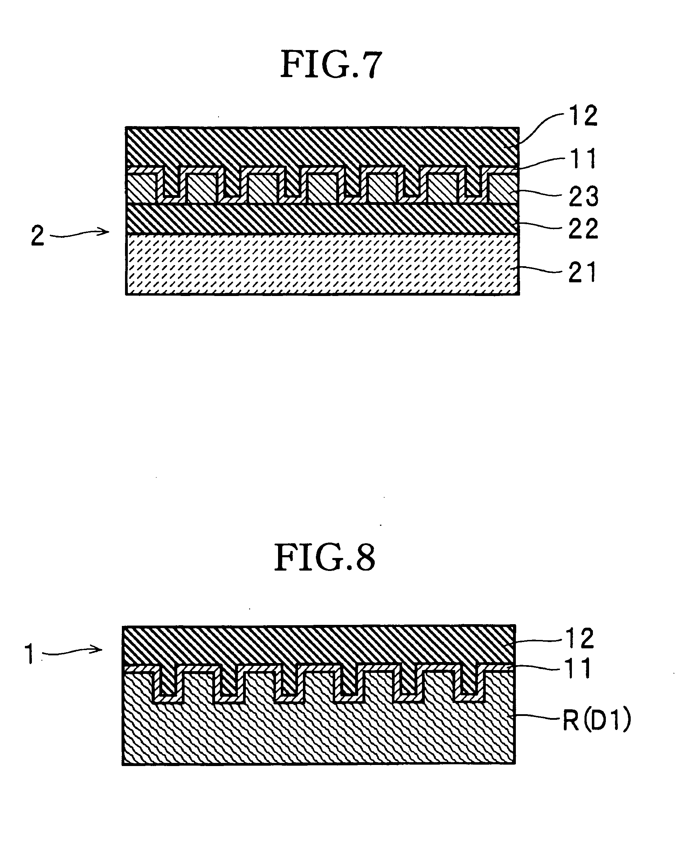

Further, as shown in Figure 7, the laminate forming apparatus 106 conducts electrolytic plating processing on the electroless nickel layer 11 using the electroless nickel layer 11 as an electrode, whereby an electrolyte nickel layer 12 is formed on the electroless nickel layer 11.

Then, a laminate consisting of the resin layer 22, the photoresist layer 23, the electroless nickel layer 11 and the electrolyte nickel layer 12 is immersed in an aqueous solution of 20 weight % of sodium hydrate, for example, and the resin layer 22 and the photoresist layer 23 are dissolved, thereby being removed from the electroless nickel layer 11 and the electrolyte nickel layer 12. Since an aqueous solution of sodium hydrate has higher alkalinity than that of the ordinary photoresist remover solution, the photoresist layer 23 can be dissolved together with the resin layer 22 in a short time, for example, in three minutes.

Thus, the stamper 1 shown in Figure 1 is manufactured. Since the pits 2a of the pit pattern formed in the photoresist layer 23 of the photoresist-coated glass board 2 are formed so as to have a desired depth, each of convex portions 1a, namely, the negative pit pattern of the pits 2a formed in the thus fabricated stamper 1 is accurately formed so as to have a desired height (projection length).

Figures 8 and 9 show steps of a process for manufacturing a disc-like substrate for an optical recording medium using the thus fabricated stamper 1.

The stamper 1 is first set in a mold for injection molding and, as shown in Figure 8, a resin R is injected into the mold. As a result, as shown in Figure 9, the pit pattern 1a of the stamper 1 is transferred onto the resin R and a disc-like substrate D1 for an optical recording medium formed with a pit pattern D1a on the surface thereof is manufactured. As described above, since the pit pattern of the stamper 1 is formed so as to have a desired height, the pit pattern D1a of the thus fabricated disc-like substrate D1 is accurately formed so as to have a desired depth. Therefore, when data recorded in an optical recording medium fabricated using the disc-like substrate D1 are read, it is possible to reliably prevent jitter error and read data recorded in the optical recording medium in a desired manner.

### WORKING EXAMPLE AND COMPARATIVE EXAMPLE

Hereinafter, a working example and a comparative example will be set out in order to further clarify the advantages of the present invention.

### Working Example

A photoresist layer 23 having a thickness of 60 nm was formed on a resin layer 22 on a glass board 21 in the above described manner and a laser beam L emitted from the exposing apparatus 103 and having a wavelength λ of 266 nm was projected onto the photoresist layer 23 so that the half-width I of the shortest pit was equal to 138 nm and a pit pattern was formed in the photoresist layer 23, thereby fabricating a sample #1.

A sample #2 was fabricated in the same manner as the sample #1 except that a pit pattern was formed in the photoresist layer 23 so that the half-width *l* of the shortest pit length was equal to 149 nm.

A sample #3 was fabricated in the same manner as the sample #1 except that a pit pattern was formed in the photoresist layer 23 so that the half-width *l* of the shortest pit length was equal to 160 nm.

A sample #4 was fabricated in the same manner as the sample #1 except that a pit pattern was formed in the photoresist layer 23 so that the half-width *l* of the shortest pit length was equal to 173 nm.

A sample #5 was fabricated in the same manner as the sample #1 except that a pit pattern was formed in the photoresist layer 23 so that the half-width *l* of the shortest pit length was equal to 186 nm.

The pits 2a formed in each of the thus fabricated samples #1 to #5 were observed using a scanning electron microscope. The results of the observation are shown in Table 1.

**TABLE 1**

| Sample | half-width *l*(nm) | *l*/λ | evaluation |
|---|---|---|---|
| | | | |
| Sample #1 | 138 | 0.52 | GOOD |
| | | | |
| Sample #2 | 149 | 0.56 | GOOD |
| | | | |
| Sample #3 | 160 | 0.60 | GOOD |
| | | | |
| Sample #4 | 173 | 0.65 | GOOD |
| | | | |
| Sample #5 | 186 | 0.70 | GOOD |

In the evaluation of Table 1, the sample was rated GOOD when each of the pits formed in the sample had a desired depth and a desired cross-section.

As shown in Table 1, it was found that the pits were formed in the desired manner in each of the samples #1 to #5.

### Comparative Example

A photoresist layer 23 having a thickness of 60 nm was formed on a glass board 21 provided with no resin layer and a laser beam L emitted from the exposing apparatus 103 and having a wavelength λ of 266 nm was projected onto the photoresist layer 23 so that the half-width *l* of the shortest pit was equal to 138 nm and a pit pattern was formed in the photoresist layer 23, thereby fabricating a comparative sample #1.

A comparative sample #2 was fabricated in the same manner as the comparative sample #1 except that a pit pattern was formed in the photoresist layer 23 so that the half-width *l* of the shortest pit length was equal to 149 nm.

A comparative sample #3 was fabricated in the same manner as the comparative sample #1 except that a pit pattern was formed in the photoresist layer 23 so that the half-width *l* of the shortest pit length was equal to 160 nm.

A comparative sample #4 was fabricated in the same manner as the comparative sample #1 except that a pit pattern was formed in the photoresist layer 23 so that the half-width *l* of the shortest pit length was equal to 173 nm.

A comparative sample #5 was fabricated in the same manner as the comparative sample #1 except that a pit pattern was formed in the photoresist layer 23 so that the half-width *l* of the shortest pit length was equal to 186 nm.

The pits 2a formed in each of the thus fabricated comparative samples #1 to #5 were observed using a scanning electron microscope. The results of the observation are shown in Table 2.

**TABLE 2**

| Sample | half-width *l*(nm) | *l*/λ | evaluation |
|---|---|---|---|
| | | | |
| Comparative Sample #1 | 138 | 0.52 | BAD |
| | | | |
| Comparative Sample #2 | 149 | 0.56 | BAD |
| | | | |
| Comparative Sample #3 | 160 | 0.60 | NOT GOOD |
| | | | |
| Comparative Sample #4 | 173 | 0.65 | GOOD |
| | | | |
| Comparative Sample #5 | 186 | 0.70 | GOOD |

In the evaluation of Table 2, the sample was rated GOOD when each of the pits formed in the sample had a desired depth and a desired cross-section, and the sample was rated NOT GOOD when each of the pits formed in the sample had a desired depth but did not have a desired cross-section. Further, the sample was rated BAD when the depth of the pits formed in the sample was outside of the allowable range.

As shown in Table 2, it was found that the depth of the pits was smaller than the desired depth in each of the comparative samples #1 and #2 and that pits having the desired depth were formed but the cross-section thereof varied greatly in the comparative sample #3.

To the contrary, it was found that the pits were formed in a desired manner in each of the comparative samples #4 and #5.

From the Working Example and Comparative Example, it was found that in the case where a resin layer 22 containing a benzophenone system compound was formed between the glass board 21 and the photoresist layer 23, the pit pattern could be formed in a desired manner so that the half-width *l* of the shortest pit length was equal to or shorter than 0.65λ.

The present invention has thus been shown and described with reference to a specific embodiment. However, it should be noted that the present invention is in no way limited to the details of the described arrangements but changes and modifications may be made without departing from the scope of the appended claims.

For example, in the above described embodiment, although the explanation was made as to the photoresist-coated glass board 2 and the stamper 1 for an optical recording medium, the present invention can be applied for manufacturing a discrete-track type recording medium in which a number of concentric data recording tracks are spaced apart from each other by a predetermined pitch or for manufacturing a semiconductor device.

Further, in the above described embodiment, although the resin layer 22 contains 4, 4'-bis(diethylamino) benzophenone or 4, 4'-bis (dimethylamino) benzophenone, the resin layer 22 may contain another benzophenone system compound.

Furthermore, in the above described embodiment, although the resin layer 22 having a thickness of about 150 nm was formed and the photoresist layer 23 having a thickness of about 60 nm was formed, it is not absolutely necessary to form the resin layer 22 so as to have thickness of about 150 nm and the photoresist layer 23 so as to have a thickness of about 60 nm.

According to the present invention, it is possible to provide a photoresist-coated glass board which can be formed with pits of a pit pattern in a desired manner using a laser beam having a short wavelength.

Further, according to the present invention, it is possible to provide a method for manufacturing a stamper formed with a pit pattern having a desired height.

Furthermore, according to the present invention, it is possible to provide a method for manufacturing a recording medium having a substrate formed with a pit pattern having a desired cross section.

## Claims

1. A method for manufacturing a photoresist-coated glass board comprising steps of forming a resin layer containing a benzophenone system compound on a glass board, forming a photoresist layer on the resin layer, intermittently projecting a laser beam for exposure having a wavelength λ of 100 nm to 300 nm onto the photoresist layer, forming a latent image of a pit pattern so that a half-width *l* of a shortest pit length is equal to or shorter than 0.65 λ, and developing the photoresist layer in which the latent image is formed to form a pit pattern in the photoresist layer.

2. A method for manufacturing a photoresist-coated glass board in accordance with Claim 1, wherein the resin layer is formed so as to have a thickness of 50 nm to 200 nm and the photoresist layer is formed so as to have a thickness of 30 nm to 100 nm.

3. A method for manufacturing a stamper comprising steps of forming a resin layer containing a benzophenone system compound on a substrate, forming a photoresist layer on the resin layer, intermittently projecting a laser beam for exposure having a wavelength λ of 100 nm to 300 nm onto the photoresist layer, forming a latent image of a pit pattern so that a half-width l of a shortest pit length is equal to or shorter than 0.65 λ, developing the photoresist layer in which the latent image is formed to form a pit pattern in the photoresist layer, and transferring the pit pattern.

4. A method for manufacturing a stamper in accordance with Claim 3, wherein the resin layer is formed so as to have a thickness of 50 nm to 200 nm and the photoresist layer is formed so as to have a thickness of 30 nm to 100 nm.

5. A method for manufacturing an optical recording medium comprising steps of forming a resin layer containing a benzophenone system compound on a substrate, forming a photoresist layer on the resin layer, intermittently projecting a laser beam for exposure having a wavelength λ of 100 nm to 300 nm onto the photoresist layer, forming a latent image of a pit pattern so that a half-width 1 of a shortest pit length is equal to or shorter than 0.65 λ, developing the photoresist layer in which the latent image is formed to form a pit pattern in the photoresist layer, transferring the pit pattern to fabricate a stamper, and transferring the pit pattern transferred onto the stamper onto a substrate for a recording medium to fabricate the substrate for an optical recording medium.

6. A method for manufacturing an optical recording medium in accordance with Claim 5, wherein the resin layer is formed so as to have a thickness of 50 nm to 200 nm and the photoresist layer is formed so as to have a thickness of 30 nm to 100 nm.
